# EUROPÄISCHE PATENTSCHRIFT

(11) **EP 0 557 776 B1**
(45) Veröffentlichungstag und Bekanntmachung des Hinweises auf die Patenterteilung: **04.06.1997**
(21) Anmeldenummer: 93101928.5
(22) Anmeldetag: 08.02.1993
(51) Int. Cl.: F21Q 3/00, F21K 7/00

(54) **Anzeigeelement**
Indicator lamp
Voyant lumineux

(30) Priorität: 28.02.1992 DE 9202608 U
(43) Veröffentlichungstag der Anmeldung: 01.09.1993
(73) Patentinhaber: EBT Licht-Technik GmbH, D-67098 Bad Dürkheim (DE)
(72) Erfinder: Klug, Georg, W-6702 Bad Dürkheim (DE)
(74) Vertreter: Klose, Hans, Dipl.-Phys.

(56) Entgegenhaltungen:
- DE-A- 2 557 808
- GB-A- 1 372 028
- GB-A- 2 082 748
- US-A- 2 777 942
- US-A- 3 031 655
- US-A- 3 276 014
- US-A- 3 659 093
- US-A- 3 887 803
- US-A- 4 358 708
- US-A- 5 068 771
- PATENT ABSTRACTS OF JAPAN vol. 17, no. 574 (M-1498)19. Oktober 1993 & JP-A-05 166 404 (FUJI ELECTRIC CO. LTD.) 2. Juli 1993

## Beschreibung

Die Erfindung bezieht sich auf ein Anzeigeelement, welches eine lichtdurchlässige Kappe enthält, gemäß den im Oberbegriff des Patentanspruchs 1 angegebenen Merkmalen.

Aus der GB-A-1 372 028 ist ein derartiges Anzeigeelement bekannt, welches eine von vorn in eine Hülse eingesetzte, lichtdurchlässige Kappe enthält. Zwischen der Kappe und der Hülse ist ein Dichtelement angeordnet und ein zylindrischer Rand der Kappe liegt an einer zylindrischen Innenfläche der Hülse an. Zur Befestigung der Kappe in der Hülse sind zwar keine näheren Angaben gemacht, doch kann bei einer herkömmlichen Verbindung mittels Klebstoff nicht ausgeschlossen werden, daß die Kappe aus der Hülse gelöst wird. Die Kappe und eine Schutzhülse, innerhalb welcher Anschlußleitungen für das Leuchtelement liegen, sind zumindest teilweise von der Hülse umgeben. Die Kappe wird von der Vorderseite her in die Hülse eingesetzt, während die Schutzhülse zusammen mit den Anschlußleitungen und dem Leuchtelement von der Rückseite in die Hülse eingesetzt werden. Durch diese beidseitige Montage ist ein nicht unerheblicher Fertigungsaufwand gegeben, da Fertigungsautomaten entweder eine beidseitige Bestückung ermöglichen oder aber geeignete Aufnahme- und/oder Wendevorrichtungen für die Hülse aufweisen müßten.

Ferner ist aus der US-A-4 358 708 ein Anzeigeelement bekannt, welches eine Hülse mit einer Stufe zur Festlegung eines Flansches des Leuchtelements aufweist. Das Leuchtelement ist als eine herkömmliche LED mit einem Gehäuse und angeformtem Flansch ausgebildet, wobei im Inneren des Gehäuses der lichtemittierende Chip oder die Leuchtdiode angeordnet sind. Das Gehäuse dieser LED ist gänzlich ungeschützt und die Hülse sowie eine Schutzhülse dienen zur Arretierung des Flansches und zur Kapselung der Anschlußelemente und eines Vorschaltwiderstands.

Desweiteren ist aus der US-A-3 276 014 ein Gehäuse für eine Anzeigelampe bekannt, wobei die lichtdurchlässige Kappe wiederum von der Vorderseite her in die aus Metall bestehende Schutzhülse eingesetzt ist. Von der Rückseite her sind in die Hülse ein Lampensockel ebenso wie die Lampe selbst eingesetzt und zur Festlegung des Sockels enthält die Hülse radiale Ausnehmungen, in welche nach dem Einsetzen Rasthebel des Sockels einrasten. Im Bereich dieser Ausnehmungen und Rastnasen kann Feuchtigkeit oder Schmutz in den Innenraum eindringen und es sind daher zusätzliche Maßnahmen für die Funktionssicherheit und den elektrischen Berührungsschutz erforderlich.

Schließlich ist aus der US-A-3 659 093 ein Anzeigeelement mit einem Gehäuse bzw. einer Hülse bekannt, an deren hinteren Ende ein Sockel für die Lampe angeordnet ist. Am vorderen Ende enthält die Hülse radial nach außen gebogene Flanschteile, an welchen eine Kappe sowie ein ringförmiges Element zur Drehsicherung und Festlegung an einer Frontplatte befestigt sind. Die Kappe liegt vorn an den genannten flanschartigen Teilen an und besitzt axial zum hinteren Ende gerichtete Zungen, welche die Hülse außen übergreifen. Das ringförmige Element umgibt an der Vorderseite der Frontplatte die flanschartigen Teile der Hülse sowie die Kappe und muß vergleichsweise stark ausgebildet sein, um beim Einwirken von äußeren Kräften eine Beschädigung oder gar ein Loslösen des Anzeigeelements zu verhindern.

Bedingt durch ihren physikalischen Aufbau können kleine Anzeigeelemente mit Glühlampen und Leuchtdioden üblicherweise nicht direkt an Netzspannungen von 110 bis 250 VAC betrieben werden, um insbesondere für Kontrollfunktionen von "an" und "aus" genügend Helligkeit zu gewährleisten. Eine sichere Anzeigefunktion kann erfahrungsgemäß mit einer Spannung bis zu 60 V AC oder DC realisiert werden. Hingegen können Anzeigeelemente mit Glimmlampen aufgrund ihrer Eigenschaften direkt für die erwähnten Netzspannungen zum Einsatz gelangen.

Der Erfindung liegt die Aufgabe zugrunde, ein Anzeigeelement der genannten Art dahingehend weiterzubilden, daß bei kompakter Bauweise eine funktionssichere Anzeige mit ausreichender Helligkeit erreicht wird. Das Anzeigeelement soll insbesondere auf der Basis der LED-Technologie aufgebaut sein und ferner den direkten Einsatz bei Netzspannung von 110 VAC bis 250 VAC ermöglichen. Das Anzeigeelement soll derart aufgebaut sein, daß unter weitgehend übereinstimmender Ausbildung der wesentlichen Bestandteile wahlweise eine LED, eine Multi-LED mit vier oder mehr LED-Chips, eine Glimmlampe oder vergleichbare Leuchtelemente eingebaut werden können. Es soll ein zuverlässiger Berührungsschutz gegeben sein und den Sicherheitsanforderungen muß entsprochen werden. Ferner soll das Anzeigeelement die Aufnahme von Vorschalt-Bauelementen, wie insbesondere Vorschaltwiderstände oder Dioden ermöglichen. Schließlich soll das Anzeigeelement einen geringen Fertigungsaufwand erfordern und in einfacher Weise zu montieren sein.

Die Lösung dieser Aufgabe erfolgt nach den im kennzeichnenden Teil des Patentanspruchs 1 angegebenen Merkmalen.

Das erfindungsgemäß vorgeschlagene Anzeigeelement zeichnet sich durch eine kompakte und funktionssichere Konstruktion aus. Das Leuchtelement, welches insbesondere als eine Glimmlampe ausgebildet ist, wird zusammen mit einer Linse und/oder Kappe sowie einer Berührungs-Schutzhülse in der weiteren Hülse, die nachfolgend als Gewindehülse bezeichnet wird, festgelegt. Diese weitere Hülse besteht zweckmäßig aus Metall und ist außen bevorzugt mit einem Gewinde versehen. Das Anzeigeelement ist auch bei Ausbildung des Leuchtelements auf LED-Basis für den direkten Anschluß an die üblichen Netzspannungen von 110 VAC und 250 VAC ausgelegt. Bei Ausführung mit einer Glimmlampe entspricht es nach außen dem Aufbau und Aussehen einem LED-enthaltenden Anzeigeelement. Die Schutzhülse und ebenso die Kappe mit der Linse bestehen aus Kunststoff, wobei im Innenraum der Schutzhülse die elektrischen Anschlüsse, Kontakte oder Vorschaltbauteile gegen Berührung gesichert angeordnet sind. Unabhängig von der jeweiligen konkreten Ausbildung des Leuchtelements, können die übrigen Bauteile zum Einsatz gelangen, wodurch der Fertigungsaufwand und Lagerhaltungsaufwand auf ein Minimum reduziert wird. Das Leuchtelement kann direkt in die Kappe eingesetzt werden, wobei hier vor allem auf sechsfach Multi-LEDs hingewiesen sei. Hierbei liegt das Leuchtelement mit seiner Außenfläche unmittelbar, zweckmäßig über Schiebe- oder Preßsitz, an der Innenfläche der Kappe an und ist somit in der gewünschten axialen Position fixiert. Zweckmäßig sind für diese Ausführungsformen die Außenfläche des Leuchtelements sowie die Innenfläche der Kappe im wesentlichen zylindrisch ausgebildet.

Für größere Ausführungsformen ist das Leuchtelement in einem Ringkörper einsetzbar und bedarfsweise durch Schweißen, Kleben oder dergleichen zu befestigen. Der Ringkörper weist zweckmäßig eine als Reflektor ausgebildete Innenfläche auf, welche das Leuchtelement, sei es eine Multi-LED oder eine Glimmlampe, umgibt und das ausgesandte Licht nach vorn in Richtung zu einer Linse reflektiert. Die Kappe mit der Linse weist ebenso wie der Ringkörper einen radialen Flansch auf, welcher gegen eine Anlagefläche der Gewindehülse zur Anlage bringbar sind. Die Schutzhülse, deren offenes Ende gleichfalls in die Gewindehülse eingeschoben und insbesondere eingepreßt ist, gewährleistet zuverlässig einen Schutz gegen Berührung. Das bestehende Farbspektrum der LEDs besteht aus den monochromatischen Farben Rot-Orange-Gelb und Grün. Durch den Einsatz von Glimmlampen werden intensive Farben im Grün- und Blaubereich erhalten. Weiterhin haben die Glimmlampen Preisvorteile und bieten in der vorgeschlagenenen Anzeigebauform das Aussehen einer modernen LED-Anzeige.

Zweckmäßige Ausgestaltungen und besondere Weiterbildungen der Erfindung sind in den Unteransprüchen angegeben und werden nachfolgend beschrieben.

Die Erfindung wird nachfolgend anhand der in der Zeichnung dargestellten Ausführungsbeispiele näher erläutert. Es zeigen:
- Fig. 1: einen axialen Längsschnitt durch das Anzeigeelement mit einer Multi-LED,
- Fig. 2: einen Längsschnitt durch das Anzeigeelement mit einer Glimmlampe,
- Fig. 3: einen Längssschnitt durch ein Anzeigeelement mit kleineren Abmessungen.

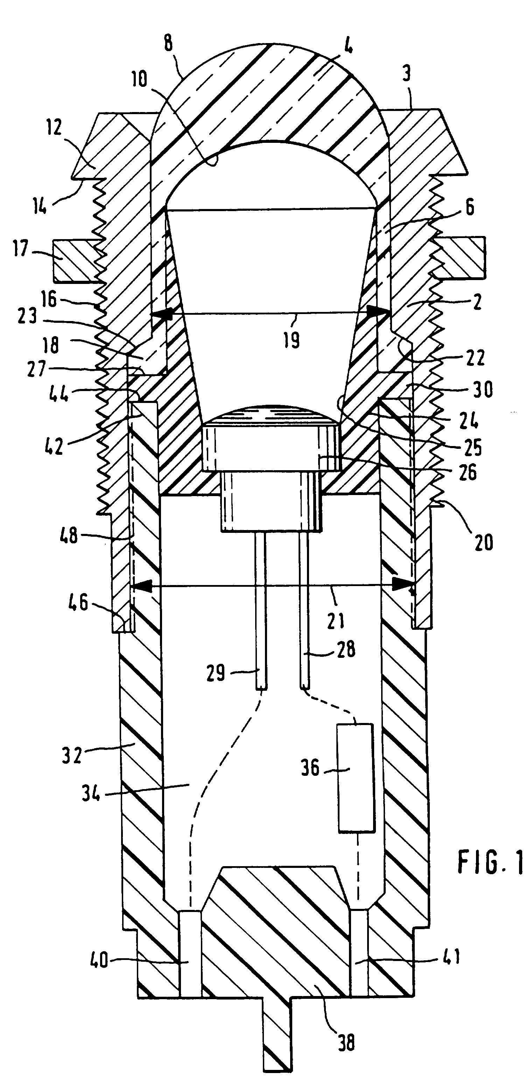

Fig. 1 zeigt in einem axialen Längsschnitt eine Gewindehülse 2, welche aus Metall besteht und als Metallreflektor ausgebildet ist. Die Gewindehülse 2 weist am vorderen Ende eine Öffnung auf, in welche eine Linse 4 eingesetzt ist, welche Bestandteil einer hohlzylindrischen, lichtdurchlässigen Kappe 6 ist. Die Kappe mit der Linse 4 besteht aus Kunststoff, wobei die vordere Außenfläche 8 und/oder die Innenfläche 10 erodiert sind, wodurch zweckmäßig eine Streuung des Lichts erreicht wird. Die als Metallreflektor ausgebildete Gewindehülse 2 weist außen an ihrem vorderen Teil einen radialen Ansatz 12 mit einer Anlagefläche 14 auf, welche nach dem Einbau in eine Schalttafel oder dergleichen an deren Vorderfläche anliegt. Im übrigen weist die Gewindehülse 2 ein Außengewinde 16 auf, welche das Festschrauben mittels einer Mutter 17 ermöglicht.

Die Kappe 6 enthält an ihrem hinteren Ende einen radialen Flansch 18, dessen Außendurchmesser größer ist als die im übrigen zylindrisch ausgebildeten Kappe 6. Die Gewindehülse 2 weist vorn einen Innendurchmesser 19 auf und besitzt etwa in der Mitte ihrer Längserstreckung eine Erweiterung, welche auf den Außendurchmesser des genannten Flansches 18 abgestimmt ist und somit das Einschieben der Kappe in die Gewindehülse 2 durch deren hinteren Endteil 20 ermöglicht. Im hinteren Teil besitzt die Hülse 2 einen im Vergleich mit dem vorderen Innendurchmesser 19 vergrößerten Innendurchmesser 21. Wie ersichtlich, ist die Gewindehülse 2 im wesentlichen in ihrer Mitte mit einer Stufe 22 versehen, an welcher der Flansch 18 der Kappe 6 mit einer vorderen Anlagefläche 23 anliegt. Die Kappe 6 kann folglich nicht nach vorn abgezogen werden. Die in zweckmäßiger Weise aus Metall bestehende Hülse 2 umgibt die Kappe 6 über einen wesentlichen Teil der Gesamtlänge, wobei über das vordere Ende 3 lediglich noch ein vergleichsweise kleiner Teil der Kappe vorsteht. Die Kappe und das in dieser angeordnete Leuchtelement 26 ist somit gegen äußere Einwirkungen in optimaler Weise geschützt.

Es ist ferner ein Ringkörper 24 vorgesehen, welcher als Kunststoffreflektor ausgebildet ist und teilweise in den Hohlraum der Kappe 6 hineinragt. Der Ringkörper 24 weist eine als Reflektorfläche 25 dienende Innenfläche auf. Der Ringkörper 24 dient ferner zur Befestigung und Aufnahme des Leuchtelements 26, welches hier als eine sechsfache Multi-LED ausgebildet ist. Wird das Leuchtelement 26 über seine Anschlußleiter 28, 29 mit Stron versorgt, so sendet es nach vorn Licht aus, welches vom Kunststoffreflektor des Ringkörpers 24 nach vorn gerichtet und durch die Linse 4 gebündelt ausgestrahlt wird. Der Ringkörper hat außen einen Flansch 30, welcher an der hinteren Endfläche der Kappe 6 bzw. deren Flansch 18 anliegt. Entsprechend kann auch der Ringkörper 24 mit dem zuvor eingesetzten und befestigten Leuchtelement 26 durch das hintere Endteil 20 eingesetzt und in die dargestellte Lage gebracht werden.

Schließlich enthält die Schutzhülse 32 einen Innenraum 34 zur Aufnahme der Anschlußleiter 28, 29 sowie ggfs. erforderlicher Vorschaltbauteile, wie der hier dargestellte Widerstand 36. Die Schutzhülse 32 besteht aus Kunststoff und bildet einen Berührungsschutz für die im Innenraum 34 befindlichen elektrischen und ggfs. spannungführenden Leitungen und Bauteile. Die Schutzhülse 32 enthält einen Boden 38 mit Öffnungen 40, 41 für hier nicht weiter dargestellte Kontaktelemente, über welche der elektrische Anschluß erfolgt. Wie ersichtlich, ist die Schutzhülse 32 mit ihrem vorderen, offenen Ende 42 in die Gewindehülse 2 eingesetzt und umgibt dort teilweise den Ringkörper 24. Die axiale Stirnfläche 44 der Schutzhülse 32 liegt am Flansch 30 des Ringkörpers 24 an, wodurch eine definierte axiale Festlegung gegeben ist. Die Schutzhülse 32 weist außen eine kleine Stufe 46 auf, welche am hinteren Endteil 20 der Gewindehülse 2 anliegt. Die Schutzhülse 32 ist mit ihrem vorderen Ende 42 in das hintere Endteil 20 der Hülse bzw. Gewindehülse 2 fest eingesetzt. Hierzu weist die Außenfläche des Endteils 42 bevorzugt kleine radial nach außen stehende, durch gestrichelte Linien angedeutete Stege 48 auf, welche zuverlässig einen festen Preßsitz gewährleisten. Diese, in axialer Richtung verlaufende Stege 48 sind in zweckmäßiger Weise leicht konisch ausgebildet derart, daß sie im Bereich der Stirnfläche 44 praktisch verschwinden und zur Stufe hin 46 erweitern. Die Schutzhülse 32 kann somit leicht in das Endteil 20 eingesetzt werden, um dann mit zunehmender Eindringtiefe mit erhöhtem Druck eingepreßt zu werden.

Der aus Kunststoff bestehende Ringkörper 24 ist teilweise im vorderen Ende der Schutzhülse 32 und teilweise innerhalb der Kappe 6 angeordnet. Der Ringkörper 24 überlappt in beiden axialen Richtungen die Kappe 6 sowie die Schutzhüllse 32. Selbst wenn infolge von Fertigungstoleranzen die Schutzhülse 32 nicht weit genug in die metallische Gewindehülse 2 eingepreßt ist, wird ein eventueller Spannungsüberschlag infolge eines Spaltes sicher verhindert. Zudem ist die Länge der Schutzhülse in zweckmäßiger Weise derart vorgegeben, daß die an Spannung liegenden Anschlußleiter 28, 29 in einem möglichst großen Abstand zu der Stirnfläche 44 und einem eventuell dort möglichen Spalt liegen, so daß Spannungsüberschläge sicher verhindert werden.

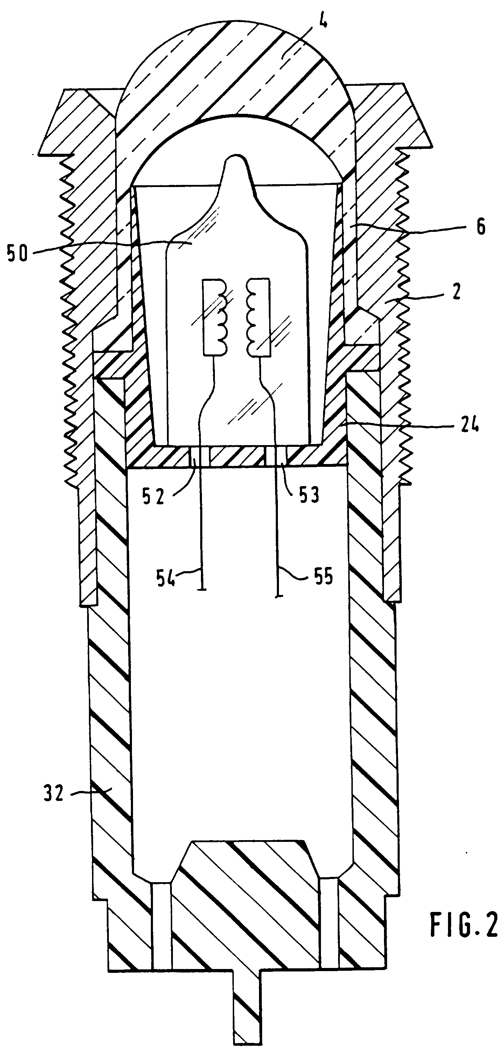

Fig. 2 zeigt eine weitere Ausgestaltung, bei welcher das Leuchtelement als eine Glimmlampe 50 ausgebildet ist. Die Glimmlampe 50 ist wiederum in dem Ringkörper 24 angeordnet, welcher in seinem Boden zwei Durchbrechungen 52, 53 für die Anschlußleiter 54, 55 der Glimmlampe 50 aufweist. Der Ringkörper 24 entspricht im wesentlichen dem der anhand von Fig. 1 dargestellten Ausführungsform und ist gleichfalls als Kunststoffreflektor ausgebildet. Wie ersichtlich, sind sämtliche übrigen Bauteile, und zwar die Gewindehülse 2, die Kappe 6 mit der Linse 4 sowie die Schutzhülse 32 übereinstimmend mit der vorher erläuterten Ausführungsform ausgebildet und auf die diesbezüglichen Erläuterungen wird verwiesen. Das erfindungsgemäße Anzeigeelement mit der Glimmlampe 50 weist die gleichen Außenabmessungen auf wie das Anzeigeelement wie das Anzeigeelement mit der Multi-LED, wobei ein gegenseitiger Austausch bedarfsweise ohne weiteres möglich ist. Da unabhängig von der konkreten Ausbildung des Leuchtelements, sei es als Glimmlampe oder als Multi-LED oder dergleichen, im übrigen übereinstimmende Bauteile zum Einsatz gelangen, wird zudem in besonders zweckmäßiger Weise der Aufwand für Fertigung, Montage und Lagerhaltung auf ein Minimum reduziert.

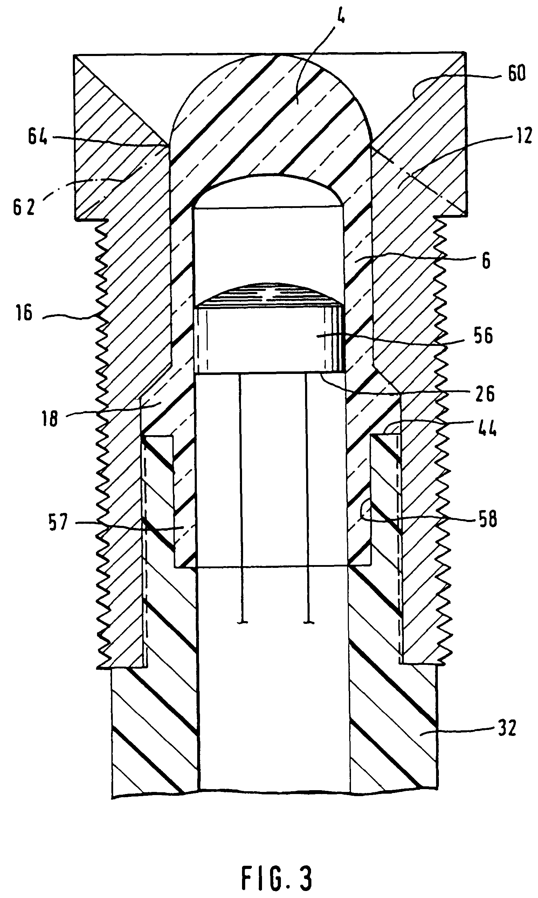

Fig. 3 zeigt eine Ausführungsform, welche im Vergleich mit den beiden oben erläuterten Anzeigeelementen kleinere Abmessungen aufweist und keinen Ringkörper bzw. Kunststoffreflektor enthält. Das Leuchtelement 26 ist unmittelbar in die Kappe 6 mit der Linse 4 eingesetzt und insbesondere als eine vierfache Multi-LED ausgebildet. Die Schutzhülse 32 liegt mit ihrer Stirnfläche 44 unmittelbar an dem Flansch 18 der Kappe 6 an. Das Leuchtelement 26 liegt mit seiner Außenfläche 56 fest an der in zweckmäßiger Weise zylindrisch ausgebildeten Innenfläche der Kappe 6 an. Bei der hier dargestellten Ausführungsform ist die Außenfläche 56 des Leuchtelements 26 gleichfalls zylindrisch ausgebildet, doch könnten entsprechende Noppen, radiale Ansätze oder dergleichen im Bereich der Außenfläche 56 vorgesehen sein, welche eine feste Anlage und einen stabilen Sitz des Anzeigeelements 26 in der Innenfläche der Kappe 6 sicherstellen. Die Außendurchmesser der Außenfläche 56 oder gegebenenfalls vorgesehener Noppen oder dergleichen sind derart auf den Innendurchmesser der Innenfläche der Kappe 6 abgestimmt, daß das Leuchtelement 26 zwar von hinten her in die Kappe 6 mit Schiebesitz oder Preßsitz eingeschoben werden kann, danach aber die einmal eingenommene Position dauerhaft beibehält. Auch über eine Klebeverbindung kann eine funktionssichere und unmittelbare axiale Festlegung des Leuchtelements 26 in der lichtdurchlässigen Kappe 6 erfolgen.

Die Kappe 6 weist ferner eine Verlängerung 57 auf, welche insbesondere 3 mm lang ist und vorn in die Schutzhülse 32 hineinragt. Die Schutzhülse 32 weist zur Aufnahme der Verlängerung 57 eine ringförmige Ausnehmung 58 auf. Aufgrund dieser besonderen Ausgestaltung wird ein unzulässiger Spalt zwischen der Stirnfläche 44 und dem Flansch 18 vermieden, da ein derartiger Spalt ggfs. zu unerwünschten Spannungsüberschlägen zwischen den Anschlußleitern 28, 29 und der metallischen Gewindehülse 2 führen könnte. Die Schutzhülse 32 und die Kappe 6 weisen im wesentlichen den gleichen Innendurchmesser auf.

Bei allen Ausführungsformen ist die Schutzhülse 32 in die umgebende, als Metallreflektor ausgebildete Hülse 2, welche ferner als Gewindehülse mit Außengewinde 16 ausgebildet ist, fest eingesetzt, wobei bevorzugt durch einen Preßsitz eine stabile und dauerhafte Verbindung gewährleistet ist. Die Gewindehülse 2 enthält in dem Ansatz 12 eine Reflektorfläche 60. Es handelt sich hierbei um einen Innenreflektor. Durch die strichpunktierte Linie 62 ist eine alternative Ausgestaltung mit einem Außenreflektor angedeutet. Bei dieser Ausgestaltung steht somit die Linse teilweise über die Frontkante 64 der Gewindehülse 2 vor und es ist eine gute Sichtbarkeit von der Seite her gegeben.

### Bezugszeichen

- 2: Hülse, Gewindehülse
- 3: vorderes Ende
- 4: Linse
- 6: Kappe
- 8: Außenfläche von 4
- 10: Innenfläche von 4
- 12: Ansatz
- 14: Anlagefläche
- 16: Außengewinde
- 17: Mutter
- 18: Flansch von 6
- 19: Innendurchmesser von 2
- 20: hinteres Endteil von 2
- 21: vergrößerter Innendurchmesser von 2
- 22: Stufe in 2
- 23: vordere Anlagefläche von 6
- 24: Ringkörper
- 25: Reflektorfläche
- 26: Leuchtelement
- 27: hintere Endfläche von 6
- 28, 29: Anschlußleiter
- 30: Flansch von 24
- 32: Schutzhülse
- 34: Innenraum
- 36: Widerstand
- 38: Boden von 32
- 40, 41: Öffnung
- 42: vorderes Ende von 32
- 44: Stirnfläche von 32
- 46: Stufe von 32
- 48: Steg
- 50: Glimmlampe
- 52, 53: Durchbrechung
- 54, 55: Anschlußleiter von 50
- 56: Außenfläche
- 57: Verlängerung
- 58: Ausnehmung
- 60: Reflektorfläche
- 62: Linie
- 64: Frontkante

## Patentansprüche

1. Anzeigeelement, enthaltend eine lichtdurchlässige Kappe (6), in oder hinter welcher zumindest teilweise ein Leuchtelement (26, 50) angeordnet ist, sowie eine Schutzhülse (32), in deren Innenraum Anschlußleiter (54, 55) des Leuchtelements (26, 50) angeordnet sind, wobei die Kappe (6) und die Schutzhülse (32) zumindest teilweise von einer Hülse (2) umgeben sind,
dadurch gekennzeichnet, daß die Hülse (2) im Inneren eine Stufe (22) aufweist, wobei ein hinterer Teil der Hülse (2) einen größeren Innendurchmesser (21) aufweist als ein vorderer Teil der Hülse (2),
daß die Kappe (6) eine vordere Anlagefläche (23) aufweist, welche an der genannten Stufe (22) anliegt,
daß die Kappe (6) und das Leuchtelement (26, 50) durch den hinteren Teil der Hülse (2) hindurch in diese eingesetzt sind,
und daß das Leuchtelement (26, 50) entweder in einem Ringkörper (24) mit einem Flansch (30), welcher zwischen einer hinteren Endfläche (27) der Kappe (6) und einer vorderen Stirnfläche (44) der Schutzhülse (32) angeordnet ist, oder direkt in der Kappe (6) befestigt ist.

2. Anzeigeelement nach Anspruch 1, dadurch gekennzeichnet, daß die Hülse (2) als Reflektor ausgebildet ist und an ihrem vorderen Ende eine Anlagefläche (14) aufweist.

3. Anzeigeelement nach Anspruch 1 oder 2, dadurch gekennzeichnet, daß die Hülse (2) aus Metall besteht und als Gewindehülse mit einem Außengewinde (16) ausgebildet ist.

4. Anzeigeelement nach einem der Ansprüche 1 bis 3, dadurch gekennzeichnet, daß das Leuchtelement als eine Glimmlampe (50) oder als Mehrfach-Leuchtdiode (26), mit insbesondere vier oder mehr LED-Chips, ausgebildet ist.

5. Anzeigeelement nach einem der Ansprüche 1 bis 4, dadurch gekennzeichnet, daß die Kappe (6) einen Flansch (18) aufweist und von der Gewindehülse (2) im wesentlichen umgeben ist, wobei der radial nach außen erweiterte Flansch (18) im hinteren Endteil (20) der Gewindehülse (2) angeordnet ist und/oder daß der Flansch (18) der Kappe (6) mit einer vorderen Fläche (23) an einer Anlagefläche (22) der Gewindehülse (2) anliegt.

6. Anzeigeelement nach einem der Ansprüche 1 bis 5, dadurch gekennzeichnet, daß die Schutzhülse (32) aus Kunststoff besteht und als Berührungsschutz ausgebildet ist und/oder daß die Schutzhülse (32) in ihrem Boden (38) Öffnungen (40, 41) für Kontaktelemente oder dergleichen aufweist.

7. Anzeigeelement nach einem der Ansprüche 1 bis 6, dadurch gekennzeichnet, daß ein insbesondere als Kunststoffreflektor ausgebildeter Ringkörper (24) vorgesehen ist, welcher zumindest teilweise in die Kappe (6) hineinragt und/oder daß der Ringkörper (24) einen radial nach außen gerichteten Flansch (30) aufweist, welcher zwischen dem Flansch (18) der Kappe (6) und einer axialen Stirnfläche (44) der Schutzhülse (32) angeordnet ist.

8. Anzeigeelement nach Anspruch 7, dadurch gekennzeichnet, daß der Ringkörper (24) topfartig ausgebildet ist, und eine bevorzugt sich konisch nach vorn öffnende reflektierende Innenfläche (10) sowie einen Boden aufweist, durch welchen das Leuchtelement (26, 50) und/oder die Anschlußleiter (28, 29) in den Innenraum (34) der Schutzhülse (32) geführt sind.

9. Anzeigeelement nach einem der Ansprüche 1 bis 8, dadurch gekennzeichnet, daß bevorzugt für kleine Abmessungen die Schutzhülse (32) mit ihrer Stirnfläche (44) direkt am Flansch (18) der Kappe (6) anliegt und/oder daß die Kappe (6) eine das vordere Ende der Schutzhülse (32) überlappende ringförmige Verlängerung (57) aufweist, wobei die Schutzhülse (32) eine diese Verlängerung (56) aufnehmende Ausnehmung (58) enthält.

## Revendications

1. Voyant lumineux, contenant un capuchon transparent (6), dans ou derrière lequel est placé au moins partiellement un élément lumineux (26, 50), ainsi qu'une douille protectrice (32) à l'intérieur de laquelle sont placés des conducteurs de branchement (54, 55) de l'élément lumineux, le capuchon (6) et la douille protectrice (32) étant au moins entourés d'une douille (2),
***caractérisé en ce que*** la douille (2) présente à l'intérieur un épaulement (22), une partie arrière de la douille (2) présentant un diamètre intérieur (21) supérieur à celui de la partie avant de la douille (2),
***en ce que*** le capuchon (6) présente une surface d'appui frontale (23) qui s'appuie contre ledit épaulement (22),
***en ce que*** le capuchon (6) et l'élément lumineux (26, 50) sont insérés dans la douille (2) à travers la partie arrière de celle-ci,
et ***en ce que*** l'élément lumineux (26, 50) est fixé dans un corps annulaire (24) avec une bride (30), laquelle est placée entre une surface d'extrémité arrière (27) du capuchon (6) et une surface frontale avant (44) de la douille protectrice (32), ou directement dans le capuchon (6).

2. Voyant lumineux selon la Revendication 1, ***caractérisé en ce que*** la douille (2) est conformée en réflecteur et présente sur son extrémité avant une surface d'appui (14).

3. Voyant lumineux selon la Revendication 1 ou 2, ***caractérisé en ce que*** la douille (2) est en métal et est conformée en douille filetée avec un filetage extérieur (16).

4. Voyant lumineux selon l'une quelconque des Revendications 1 à 3, ***caractérisé en ce que*** le voyant lumineux est conformé en lampe à incandescence (50) ou en diode lumineuse multiple (26), avec en particulier quatre puces DEL ou plus.

5. Voyant lumineux selon l'une quelconque des Revendications 1 à 4, ***caractérisé en ce que*** le capuchon (6) présente une bride (18) et est entouré pour l'essentiel par la douille filetée (2), la bride (18) élargie radialement vers l'extérieur étant placée dans la partie d'extrémité arrière (20) de la douille filetée (2) et/ou ***en ce que*** la bride (18) du capuchon (6) s'appuie avec une surface avant (23) contre une surface d'appui (22) de la douille filetée (2).

6. Voyant lumineux selon l'une quelconque des Revendications 1 à 5, ***caractérisé en ce que*** la douille protectrice (32) est en matière plastique et est conformée en protection de contact et/ou ***en ce que*** la douille protectrice (32) présente dans son fond (38) des ouvertures (40, 41) pour des éléments de contact ou analogues.

7. Voyant lumineux selon l'une quelconque des Revendications 1 à 6, ***caractérisé en ce qu'***un corps annulaire (24) formé en particulier en plastique est prévu, lequel forme saillie au moins partiellement dans le capuchon (6) et/ou ***en ce que*** le corps annulaire (24) présente une bride (30) tournée vers l'extérieur, qui est placée entre la bride (18) du capuchon (6) et une surface frontale axiale (44) de la douille protectrice (32).

8. Voyant lumineux selon la Revendication 7, ***caractérisé en ce que*** le corps annulaire (24) est conformé en pot, et présente une surface intérieure réfléchissante (10) s'ouvrant de préférence de manière conique vers l'avant, ainsi qu'un fond à travers lequel l'élément lumineux (26, 50) et/ou les conducteurs de branchement (28, 29) passent vers l'intérieur (34) de la douille protectrice (32).

9. Voyant lumineux selon l'une quelconque des Revendications 1 à 8, ***caractérisé en ce que****,* de préférence, pour des dimensions réduites, la douille protectrice (32) s'appuie avec sa surface frontale (44) directement sur la bride (18) du capuchon (6) et/ou ***en ce que*** le capuchon (6) présente un prolongement annulaire (57) recouvrant l'extrémité avant de la douille protectrice (32), la douille protectrice (32) contenant un creux (58) recevant ce prolongement (56).

## Claims

1. Indicator element, containing a translucent cap (6), in or behind which a lighting element (26, 50) is at least partially arranged, and a protective sleeve (32), in the interior of which connecting leads (54, 55) for the lighting element (26, 50) are arranged, the cap (6) and the protective sleeve (32) being at least partially surrounded by a sleeve (2), characterised in that the sleeve (2) is provided in its interior with a step (22), a rear part of the sleeve (2) having a larger internal diameter (21) than a front part of the sleeve (2), that the cap (6) has a front bearing surface (23) which bears against the said step (22), that the cap (6) and the lighting element (26, 50) are inserted into the sleeve (2) through the rear part thereof, and that the lighting element (26, 50) is secured either in an annular body (24) via a flange (30) arranged between a rear end surface (27) of the cap (6) and a front end face (44) of the protective sleeve (32) or directly in the cap (6).

2. Indicator element according to claim 1, characterised in that the sleeve (2) is a reflector and is provided at its front end with a bearing surface (14).

3. Indicator element according to claim 1 or claim 2, characterised in that the sleeve (2) consists of metal and is a threaded sleeve with an external thread (16).

4. Indicator element according to one of claims 1 to 3, characterised in that the lighting element is a glow lamp (50) or a multiple light-emitting diode (26), in particular with four or more LED chips.

5. Indicator element according to one of claims 1 to 4, characterised in that the cap (6) has a flange (18) and is substantially surrounded by the threaded sleeve (2), the radially outwardly enlarged flange (18) being arranged in the rear end part (20) of the threaded sleeve (2), and/or that the flange (18) of the cap (6) bears via a front surface (23) against a bearing surface (22) of the threaded sleeve (2).

6. Indicator element according to one of claims 1 to 5, characterised in that the protective sleeve (32) consists of plastic and is a touch-guard and/or that the protective sleeve (32) is provided in its base (38) with openings (40, 41) for contact elements or the like.

7. Indicator element according to one of claims 1 to 6, characterised by an annular body (24), in particular in the form of a plastic reflector, which projects at least partially into the cap (6), and/or in that the annular body (24) has a radially outwardly directed flange (30) arranged between the flange (18) of the cap (6) and an axial end face (44) of the protective sleeve (32).

8. Indicator element according to claim 7, characterised in that the annular body (24) is cup-shaped and has a reflective inner surface (10) preferably opening conically towards the front and a base, by means of which the lighting element (26, 50) and/or the connecting leads (28, 29) is/are guided into the interior (34) of the protective sleeve (32).

9. Indicator element according to one of claims 1 to 8, characterised in that, preferably in the case of small dimensions, the protective sleeve (32) bears via its end face (44) directly against the flange (18) of the cap (6) and/or that the cap (6) has an annular extension (57) overlapping the front end of the protective sleeve (32), the protective sleeve (32) containing a recess (58) receiving this extension (56).
